# EUROPÄISCHE PATENTSCHRIFT

(11) **EP 0 595 277 B1**
(45) Veröffentlichungstag und Bekanntmachung des Hinweises auf die Patenterteilung: **17.03.1999**
(21) Anmeldenummer: 93117369.4
(22) Anmeldetag: 27.10.1993
(51) Int. Cl.: H04B 1/30, H03D 1/22

(54) **Homodynempfänger und Verfahren zur direkten Konvertierung**
Homodyne receiver and method of direct conversion
Récepteur homodyne et procédé de conversion direct

(30) Priorität: 29.10.1992 DE 4236546
(43) Veröffentlichungstag der Anmeldung: 04.05.1994
(73) Patentinhaber: HAGENUK GMBH, D-24118 Kiel (DE)
(72) Erfinder: Behrent, Hermann, D-22958 Kuddewörde (DE)
(74) Vertreter: Hansmann, Dierk, Dipl.-Ing.

(56) Entgegenhaltungen:
- EP-A- 0 490 275
- 40TH IEEE VEHICULAR TECHNOLOGY CONFERENCE Mai 1990 , ORLANDO,FL,US Seiten 668 - 674 XP204191 SCHULTES ET AL 'A New Incoherent Direct Conversion Receiver'

## Beschreibung

Die Erfindung betrifft einen Homodynempfänger und ein Verfahren zur direkten Konvertierung (Direct Conversion-Empfänger), insbesondere von winkelmodulierten Trägersignalen, speziell auch solchen, bei denen das konvertierte Signal(ZF) einen Gleichspannungsanteil (DC-Anteil) aufweist.

Direct Conversion-Empfänger sind zum Beispiel aus DE 29 02 952 C2 bekannt. Hiernach genügt es theoretisch, das Empfangssignal gegebenenfalls nach einer Vorverstärkung mit der von einem lokalen Oszillator erzeugten Trägerfrequenz zu mischen und dabei entstehende hohe Summenfrequenzen mit einem Tiefpaß abzutrennen. Das gefilterte Signal soll dem demodulierten Signal entsprechen. Die Frequenz des lokalen Oszillators soll in einer Phasenregelschleife (Phase-Locked Loop; PLL) auf die Trägerfrequenz eingestellt werden. Die PLL zur Frequenz- und Phasenregelung ist erforderlich, weil bei gebräuchlichen Referenzsignalquellen grundsätzlich eine mehr oder minder große Frequenzabweichung zur Trägerfrequenz besteht. Die Synchronisation des lokalen Oszillators mit der Trägerfrequenz bzw. Frequenz des sendenden Oszillators muß also erst erzwungen werden. Hierzu wird der empfangene Träger als Referenzsignal für die Regelung herangezogen. Das zur Regelung des lokalen Oszillators verwendete Fehlersignal kann, wenn das empfangene Signal sehr schwach ist und auf dem Übertragungsweg gestört wird, nicht von dem bei der direkten Umsetzung des modulierten Trägersignals entstehenden DC-offset unterschieden werden. Die PLL-Regelung versagt dann.

Nach GB 2 192 506 wird das winkelmodulierte Eingangssignal in zwei Zweige aufgeteilt und zu den beiden Zweigen die Frequenz eines lokalen Oszillators zugemischt, wobei für einen Zweig eine Phasenverschiebung der zugemischten Frequenz von 90° eingestellt ist. Das Mischsignal in dem Zweig ohne Phasenverschiebung wird als in-phase Signal (I), das Mischsignal in dem Zweig mit Phasenverschiebung wird als Quadratursignal (Q) bezeichnet. Es sind Tiefpaßfilter und Analog-Digitalwandler vorgesehen. Die digitalen Signale aus beiden Zweigen werden einem digitalen Signalprozessor (DSP) zugeleitet. In diesem wird aus dem I- und Q-Signalen das demodulierte Signal berechnet. Auch die I- und Q-Signale weisen einen von der direkten Umsetzung des modulierten Trägersignals stammenden DC-offset auf. Weitere ungewollte DC-offsets können durch das Übersprechen des lokalen Oszillators auf die Signaleingänge des Mischers und durch die relative Phasenlage des lokalen Oszillators zum Träger des empfangenen Signals entstehen. Gegebenenfalls eingefügte Verstärker führen ebenfalls zu einem weiteren DC-offset. Die Gesamtheit der DC-offset-Spannungen (folgend aus Betriebstemperatur, der Alterung der Bauteile, Phasenlage, Übersprechen, Verstärker-offset) kann bei sehr kleinen Eingangssignalen etliche zehntausendmal größer sein als das Nutzsignal, so daß ein AD-Wandler einen großen Dynamikbereich haben muß, um das Nutzsignal noch auflösen zu können. Damit ist die Verwendung kostengünstiger und schneller AD-Wandler bei der erforderlichen Auflösung des Nutzsignals weitestgehend ausgeschlossen.

Für Heterodynemfpänger wurde die Verwendung eines Bandpasses für das ZF-Signal z.B. in WO 88/10033 vorgeschlagen. Damit werden alle DC-Anteile abgetrennt. Mit den abgetrennten DC-Anteilen werden aber auch DC-Anteile des konvertierten Signals durch die Bandpässe abgetrennt. Bei vielen Modulationsarten enthält der (kurzzeitige) DC-Anteil des konvertierten Signals Informationen über das modulierende Signal. Mit der Abtrennung des DC-Anteils des konvertierten Signals gehen demzufolge auch Informationen des modulierenden Signals verloren, woraus eine erhebliche Störung des demodulierten Signals folgt. Insbesondere wird der Klirrfaktor erhöht.

EP 0 473 373 A2 betrifft eine Kalibrierungseinrichtung für Homodynempfänger. Hierbei ist unter anderem vorgesehen, in den Signalzweigen für I- und Q-Signale Tiefpässe zur Unterdrückung von unerwünschten Mischprodukten und Trägerresten vorzusehen. Bei Verwendung von Tiefpässen allein wären außerordentlich aufwendige AD-Wandler mit großer Bit-Breite erforderlich.

Nach US 49 44 025 ist ein spezieller Empfänger vorgesehen, der genau gesehen, nicht mehr als Homodynempfänger bezeichnet werden kann. Vielmehr wird durch das Zumischen der Frequenz fᵤₚ eine Zwischenfrequenz erzeugt. Aus dieser wird mit einem Fehlerverstärker eine Regelung der Frequenz des lokalen Oszillators (f_{offset}) abgeleitet. Abgesehen davon, daß hier eine Regelung verwendet wird, die die bekannten Nachteile, wie Eigenschwingverhalten der Regelung aufweist, ist hier vorgesehen, den lokalen Oszillator zur Erzeugung der I- und Q-Signale mit einer Frequenzablage (f_{offset}) zu betreiben. Für diese Frequenzablage wird vorgesehen, daß sie größer als die halbe Kanalbreite (base band width) sein soll. Dies erfordert entweder eine Spiegelfrequenzselektion oder das ansich brauchbare Spektrum kann nicht vollständig genutzt werden. Insbesondere bei engen Kanalabständen ist eine Nachbarkanalinterferenz nicht zu vermeiden.

Aufgabe der Erfindung war es, einen Homodynempfänger und ein Verfahren zur direkten Konvertierung eines insbesondere winkelmodulierten Trägersignals anzugeben, bei dem einerseits bauteil- und anordnungsbedingte DC-offsets abgetrennt werden, andererseits aber die eigentlichen DC-Anteile des konvertierten Signals für die Demodulation erhalten bleiben.

Die Aufgabe wird durch einen Empfänger mit den Merkmalen des Anspruchs 1 und ein Verfahren mit den Merkmalen des Anspruchs 4 gelöst.

Der erfindungsgemäße Homodynempfänger weist für das empfangene Signal einen Signalteiler auf, mit dem das Signal in zwei Signalzweige geführt wird. Es ist ein lokaler Oszillator mit einem direkten und einem phasenverschobenen Ausgang (90°) vorhanden. Die Ausgänge des lokalen Oszillators führen zu in den Signalzweigen angeordneten Mischern zur Erzeugung des I- bzw. Q-Signals. In den beiden Signalzweigen sind Bandpässe zur Unterdrückung von unerwünschten Mischprodukten, Trägerresten und DC-offsets vorgesehen. Zweckmäßigerweise werden zusätzlich Signalverstärker in den beiden Signalzweigen angeordnet. Die beiden Signalzweige werden einem Rechenwerk, vorzugsweise einem digitalen Signalprozessor (DSP), zugeführt. Zwischen den Signalverstärkern und dem DSP sind zweckmäßigerweise geeignete Analog-Digitalwandler angeordnet. Die AD-Wandlung kann aber auch im Rechenwerk selbst erfolgen.

Erfindungsgemäß weist der verwendete lokale Oszillator eine Frequenzablage zur Trägerfrequenz des empfangenen Signals auf. Bei bisher üblichen Empfängern wurde dies möglichst zu vermeiden gesucht. Teilweise wurden sogar aufwendige Regelschleifen verwendet, um die Frequenz des lokalen Oszillators möglichst genau auf die Trägerfrequenz abzustimmen. Verglichen damit gibt die Erfindung eine gegensätzliche Lehre. Es sollen Bandpässe angeordnet werden und die Frequenz des lokalen Oszillators soll sich von der Trägerfrequenz so weit unterscheiden, daß die eigentlichen DC-Anteile des konvertierten Signals, die nominell bei der Trägerfrequenz liegen würden, in den Durchlaßbereich der Bandpässe angehoben werden. Anders ausgedrückt soll der Betrag der Frequenzablage so gewählt werden, daß er im Durchlaßbereich der Bandpässe liegt. Es kommt also nicht auf eine zufällige Abweichung der Frequenz des lokalen Oszillators von der Trägerfrequenz an, sondern die Frequenzabweichung des lokalen Oszillators von der Trägerfrequenz ist auf den unteren Durchlaßbereich der Bandpässe abgestimmt. Andererseits soll aber die Frequenz des lokalen Oszillators innerhalb des Spektrums des zu empfangenden Signals liegen, um den Sperrabstand zum Nachbarkanal nicht unnötig zu verkleinern.

Durch die Frequenzablage des lokalen Oszillators wird das Spektrum des nach den Mischern vorliegenden konvertierten Signals um die Frequenzablage verschoben. Durch die erfindungsgemäße Bemessungsregel für die Frequenzablage wird der eigentliche DC-Anteil des konvertierten Signals nicht mit dem DC-offset abgetrennt. Durch die erfindungsgemäße Auswahl der Frequenz des lokalen Oszillators in Verbindung mit der so durchgeführten AC-Kopplung wird vorteilhafterweise der Dynamikbereich für den AD-Wandler eingeschränkt ohne Informationen des modulierenden Signals zu verlieren.

Durch die erfindungsgemäß eingestellte Frequenzablage des lokalen Oszillators wird bewußt eine Verzerrung des demodulierten Signals eingestellt. Auch dies führt in eine zu der bisherigen Vorgehensweise entgegengesetzte Richtung. Die durch die Frequenzablage erzeugte Verzerrung kann im Vergleich zu den übrigen Verzerrungen, die durch den Bandpaß abgetrennt sind, relativ leicht in dem Rechenwerk kompensiert werden. Durch die erfindungsgemäße Kombination einer AC-Kopplung einerseits und der bewußten Einstellung einer Frequenzablage des lokalen Oszillators andererseits werden schwer abtrennbare Verzerrungen durch eine kompensierbare Verzerrung ersetzt. Es können kostengünstige AD-Wandler mit einem Dynamikbereich verwendet werden, der an den Dynamikbereich des Nutzsignals angepaßt ist.

Grundsätzlich muß die Frequenzablage (Differenz zwischen Frequenz des lokalen Oszillators und der Trägerfrequenz) im Durchlaßbereich des Bandpasses liegen. Die Frequenzablage muß also zwischen unterer Grenzfrequenz und oberer Grenzfrequenz des Bandpasses liegen. Da mit der Frequenzablage nicht nur der DC-Anteil des Basisbandsignals angehoben wird, sondern dies für alle Frequenzen des Basisbandsignals zutrifft, muß die Frequenzablage so gewählt werden, daß auch noch die größte zu erwartende (verschobene) Frequenz des Basisbandsignals im Durchlaßbereich des Bandpasses liegt. Es ist ferner der Sperrbereich zwischen benachbarten Übertragungskanälen zu beachten. Unter Annahme eines idealen Bandpasses kann die maximale Frequenzablage den halben Wert der Differenz zwischen dem Kanalmittenabstand und der genutzten Kanalbreite annehmen. Bei einem realen Bandpaß muß die Frequenzablage in Abhängigkeit von der Flankensteilheit kleiner sein. Die Flankensteilheit an der unteren Grenzfrequenz des Bandpasses bestimmt auch die minimal erforderliche Frequenzablage des lokalen Oszillators.

Bei den speziell beabsichtigten Anwendungen des erfindungsgemäßen Empfängers für moderne Mobilfunknetze sind strenge Restriktionen für Kanalmittenabstand und Kanalbreite vorgegeben. Typischerweise darf die Kanalbreite 60 % des Kanalabstandes betragen. Beispielsweise kann bei einem Kanalabstand von 12,5 kHz mit einer Kanalbreite von 7,5 kHz die maximale Frequenzablage bei idealen Filtern 2,5 kHz betragen. Damit geht zwar ein Teil des Spektrums durch den Bandpaß verloren, die für die Demodulation wichtigere Information über den eigentlichen DC-Anteil bleibt aber erhalten.

Der erfindungsgemäße Homodynempfänger weist ein Rechenwerk auf, das zur Kompensation der durch die konstante Frequenzablage des lokalen Oszillators von der Trägerfrequenz erzeugten Verzerrung ausgebildet ist.

Die erfindungsgemäß erzeugte Verzerrung durch die Frequenzablage ist als zusätzliche stetige Phasenänderung des modulierten Signals erkennbar. Die Demodulation kann zum Beispiel nach dem in GB 2 192 506 beschriebenen Verfahren erfolgen. Die Kompensation der durch die konstante Frequenzablage erzeugten zusätzlichen stetigen Phasenänderung kann zum Beispiel durch eine stückweise Mittelwertbildung erfolgen. Bei einer Modulation mit digitalen Informationen kann die durch die konstante Frequenzablage erzeugte Verzerrung des demodulierten Signals als Steigung einer Ausgleichsgeraden im Phasen-Zeitdiagramm bestimmt und kompensiert werden.

Nach dem erfindungsgemäßen Verfahren wird das empfangene Signal mit einer Frequenz gemischt, die sich von der Trägerfrequenz um einen bewußt eingestellten, bestimmten Betrag unterscheidet, wodurch bewußt eine Verzerrung des demodulierten Signals erzeugt wird. Durch einen Bandpaßfilter werden die Ursachen der bewußt erzeugten Verzerrungen durchgelassen, weitere Verzerrungen wie ungewollte DC-offsets, aber auch unerwünschte Mischprodukte und Trägerreste, werden abgetrennt. Hierzu wird insbesondere durch die bewußt eingestellte Frequenzablage das Basisbandsignal um den Betrag der Frequenzablage versetzt, wobei diese so gewählt ist, daß sie selbst, aber auch das versetzte konvertierte Signal, im Durchlaßbereich des Bandpasses liegt.

Insbesondere wird das konvertierte Basisband durch die Frequenzablage um einen Betrag versetzt, der kleiner ist als der halbe Wert der Differenz zwischen dem Kanalmittenabstand und der genutzten Kanalbreite.

Erfindungsgemäß wird das um die Frequenzablage versetzte Basisbandsignal digitalisiert, in einem digitalen Signalprozessor demoduliert und in der Weise korrigiert, daß die durch die Frequenzablage erzeugte Verzerrung kompensiert wird. Die Kompensation einer im Basisband als stetige zusätzliche Phasenänderung erkennbaren Verzerrung durch die Frequenzablage erfolgt zum Beispiel durch eine stückweise Mittelwertbildung mit anschließender Subtraktion. Bei einer Modulation mit digitalen Informationen ist die durch die Frequenzablage erzeugte Verzerrung als Steigung einer Ausgleichsgeraden im Phasen-Zeitdiagramm bestimmbar und kann damit kompensiert werden.

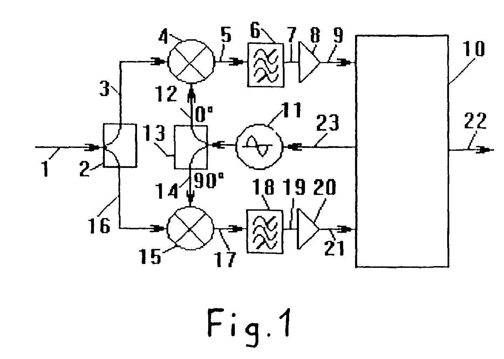

Ein Ausführungsbeispiel des erfindungsgemäßen Verfahrens wird anhand der schematischen Darstellung in Fig. 1 erläutert. Fig. 1 zeigt in schematischer Darstellung ein Blockschaltbild eines Homodynempfängers mit nachgeschaltetem Rechenwerk.

Über die Leitung 1 wird das empfangene Signal einem Signalteiler 2 zugeführt. In dem Signalteiler 2 wird das empfangene Signal in einen ersten Anteil und einen zweiten Anteil aufgeteilt. Der erste Anteil wird über die Leitung 3 einem Mischer 4 zugeführt. In dem Mischer 4 wird der erste Signalteil mit dem am direkten Ausgang 12 des lokalen Oszillators 11 anliegenden Signal gemischt. Hierdurch entsteht im Mischer 4 das In-phase-Signal (I). Dieses Signal wird über die Leitung 5 dem Bandpaß 6 zugeführt. Dort werden unerwünschte Mischprodukte, Trägerfrequenzreste, aber auch DC-offsets abgetrennt. Das gefilterte Signal wird über die Leitung 7 einem Signalverstärker 8 zugeführt. Das verstärkte Signal wird über die Leitung 9, gegebenenfalls nach Zwischenschaltung eines AD-Wandlers, dem Rechenwerk 10 zugeführt. Der zweite im Signalteiler 2 erzeugte Signalteil wird über die Leitung 16 dem Mischer 15 zugeführt. Im Mischer 15 wird das am Ausgang 13 des lokalen Oszillators 11 anliegende, über die Leitung 14 zugeführte, um 90° phasenverschobene Signal des lokalen Oszillators 11 mit dem zweiten, über die Leitung 16 zugeführten Signalteil gemischt. Das Mischprodukt, das als Quadratursignal (Q) bezeichnet wird, wird über die Leitung 17 dem Bandpaß 18 zugeführt. Die Funktion des Bandpasses 18 entspricht derjenigen des oben beschriebenen Bandpasses 6. Das gefilterte Q-Signal wird über die Leitung 19 einem Signalverstärker 20 zugeleitet. Hiervon wird es gegebenenfalls nach einer nicht dargestellten Analog-Digitalwandlung mit der Leitung 21 in das Rechenwerk 10 geführt. Im Rechenwerk 10 wird die Demodulation mittels der I- und Q-Signale durchgeführt. Hier entsteht ansich das demodulierte Signal, dies ist jedoch noch wegen der erfindungsgemäß vorgesehenen Frequenzablage des lokalen Oszillators verzerrt. Die Verzerrung ist im Phasen-Zeitdiagramm zum Beispiel, wenn das modulierende Signal Sprache ist, als stetiger überlagerter Anstieg im Phasen-Zeitdiagram erkennbar. Dieser stetige Anstieg wird im Rechenwerk durch stückweise Mittelwertbildung bestimmt und kann dann kompensiert (subtrahiert) werden. Mit der Leitung 22 wird das demodulierte, entzerrte Signal zu weiteren Baugruppen geführt.

In einer besonderen Ausführung kann vorgesehen sein, daß der lokale Oszillator 11 regelbar ist, um "spread spectrum" Anwendungen zu ermöglichen. Hierfür kann eine Steuerleitung 23 vom Rechenwerk 10 zum lokalen Oszillator 11 führen. Auch hierbei bleibt die erfindungsgemäße vorgesehene Frequenzablage erhalten.

## Patentansprüche

1. Homodynempfänger mit einem Signalteiler, einem lokalen Oszillator mit einem direkten und einem phasenverschobenen Ausgang, mit zwei Mischern zur Erzeugung von I- und Q-Signal, zwei Bandpässen zur Unterdrückung von unerwünschten Mischprodukten, Trägerresten und DC-offsets, zwei Signalverstärkern und einem Rechenwerk zur Entzerrung,wobei der lokale Oszillator (11) eine Frequenzablage zur Trägerfrequenz des empfangenen Signals hat, so daß die Differenzfrequenz zwischen Trägerfrequenz und Oszillatorfrequenz im Durchlaßbereich der Bandpässe (6, 18) liegt, dadurch gekennzeichnet, daß die Differenzfrequenz zwischen Trägerfrequenz und Oszillatorfrequenz kleiner ist als der halbe Wert der Differenz zwischen dem Kanalmittenabstand und der genutzten Kanalbreite.

2. Homodynempfänger nach Anspruch 1,dadurch gekennzeichnet, daß das Rechenwerk (10) zur Entfernung der durch die konstante Frequenzablage erzeugten stetigen Phasenänderung des modulierten Signals ausgebildet ist.

3. Homodynempfänger nach Anspruch 1 oder 2, dadurch gekennzeichnet, daß zur Einstellung auf unterschiedliche Trägerfrequenzen der lokale Oszillator (11) regelbar ist.

4. Verfahren zur direkten Konvertierung durch Aufteilung des empfangenen Signals in zwei Signalzweige, Mischung des ersten Signalzweiges mit dem Signal eines lokalen Oszillators, Mischung des zweiten Signalzweiges mit dem um 90° verschobenen Signal eines lokalen Oszillators, Bandpaßfilterung, Verstärkung, AD-Wandlung und Demodulation sowie Entzerrung in einem Rechenwerk, wobei die Signale beider Signalzweige durch eine bewußt eingestellte Frequenzablage des lokalen Oszillators von der Trägerfrequenz um den Differenzbetrag in den Durchlaßbereich des Bandpasses angehoben werden und die dadurch entstehende Verzerrung des modulierten Signals im Rechenwerk erfolgt, dadurch gekennzeichnet, daß eine Frequenzverschiebung um einen Betrag erfolgt, der kleiner als der halbe Wert der Differenz zwischen Kanalmittenabstand und der genutzten Kanalbreite ist.

## Claims

1. A homodyne receiver with a signal divider, a local oscillator having a direct and a phase-shifted output, two mixers for generating I- and Q-signal, two band-pass filters for suppressing undesired mixing products, carrier leaks and d.c. offsets, two signal amplifiers and a computational unit for equalisation, wherein the local oscillator (11) has a frequency offset relative to the carrier frequency of the received signal so that the difference frequency between carrier frequency and oscillator frequency lies in the pass band of the band-pass filters (6, 18), characterised in that the difference frequency between carrier frequency and oscillator frequency is smaller than half the value of the difference between the channel centre distance and the channel width which is used.

2. A homodyne receiver according to Claim 1, characterised in that the computational unit (10) is designed to eliminate the constant change in phase of the modulated signal produced by the constant frequency offset.

3. A homodyne receiver according to Claim 1 or 2, characterised in that the local oscillator (11) can be regulated for setting at different carrier frequencies.

4. A process for direct conversion by dividing the received signal into two signal branches, mixing the first signal branch with the signal from a local oscillator, mixing the second signal branch with the signal from a local oscillator shifted by 90°, band-pass filtering, amplification, A/D conversion and demodulation, and equalisation in a computational unit wherein, by means of an intentionally set frequency offset of the local oscillator relative to the carrier frequency, the signals of the two signal branches are lifted by the difference amount into the pass band of the band-pass filter and the resultant distortion of the modulated signal takes place in the computational unit, characterised in that a frequency shift is effected by an amount smaller than half the value of the difference between channel centre distance and the channel width which is used.

## Revendications

1. Récepteur homodyne comprenant un séparateur de signal, un oscillateur local avec une sortie directe et une sortie déphasée, deux étages mélangeurs générateurs des signaux I et Q, deux filtres passe-bande de suppression des produits de mélange indésirables, reliquats de porteuse et des seuils DC, deux amplificateurs de signal et d'une unité de calcul d'annulation de la distorsion, dans ledit récepteur la fréquence de l'oscillateur local (11) étant décalée de la fréquence porteuse du signal capté de manière telle que la fréquence de différence entre la fréquence de la porteuse et la fréquence de l'oscillateur est située dans la bande de passage des filtres passe-bande (6, 18), caractérisé par le fait que la fréquence de différence entre la porteuse et la fréquence de l'oscillateur est plus petite que la moitié de la différence entre la fréquence centrale du canal et la largeur de bande utile du canal.

2. Récepteur homodyne selon la revendication 1, caractérisé par la conception de l'unité de calcul (10) prévue de sorte à annuler les variations de phase continuelles du signal modulé engendrées par le décalage constant de la fréquence.

3. Récepteur homodyne selon les revendications 1 et 2, caractérisé par la possibilité de réglage de la fréquence de l'oscillateur local (11) pour assurer l'accord sur les différentes fréquences porteuses.

4. Procédé de conversion directe par partage du signal capté en deux voies de signal, mélange du signal de la première voie avec la signal d'un oscillateur local, mélange de la fréquence de la deuxième voie avec le signal d'un oscillateur local déphasé de 90°, filtrage par passe-bande, amplification, conversion a/n et démodulation ainsi que l'annulation de la distorsion dans une unité de calcul, dans ledit procédé les signaux des deux voies étant transposés dans la bande de passage du filtre passe-bande par un décalage délibéré de la différence en fréquence entre la fréquence de l'oscillateur local et la fréquence porteuse, l'annulation de la distorsion du signal modulé ainsi engendrée étant obtenue dans l'unité de calcul, caractérisé par un décalage de la fréquence plus petit que la moitié de la différence entre la fréquence centrale du canal et la largeur de bande utile du canal.
